(19) Europäisches Patentamt
European Patent Office
Office européen des brevets

(11) **EP 4 451 557 A1**

(12) **EUROPEAN PATENT APPLICATION**
published in accordance with Art. 153(4) EPC

(43) Date of publication:
**23.10.2024 Bulletin 2024/43**

(21) Application number: **22905727.8**

(22) Date of filing: **07.04.2022**

(51) International Patent Classification (IPC):
*H03F 1/02* *(2006.01)*

(86) International application number:
**PCT/CN2022/085456**

(87) International publication number:
**WO 2023/108957 (22.06.2023 Gazette 2023/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.12.2021 CN 202111538979**

(71) Applicant: **Shaanxi Reactor Microelectronics Co., Ltd.**
**Xi'an, Shaanxi 710000 (CN)**

(72) Inventors:
• **RUAN, Jinlong**
**Shaanxi 710000 (CN)**
• **XIA, Qin**
**Shaanxi 710000 (CN)**

(74) Representative: **Zaboliene, Reda**
**Metida**
**Business center Vertas**
**Gyneju str. 16**
**01109 Vilnius (LT)**

(54) **POWER AMPLIFICATION CIRCUIT BASED ON ENVELOPE TRACKING TECHNOLOGY AND DESIGN METHOD**

(57)    A power amplifier circuit based on envelope tracking technology and a design method thereof solve the problems of difficult efficiency guarantee of the traditional Doherty architecture power amplifier circuit and poor linearity at peak power output. The power amplifier circuit comprises a Doherty architecture and an external power supply; the external power supply is an ET power supply or APT power supply; the output terminal of the ET power supply or APT power supply is connected to a drain electrode of a first transistor in the Doherty architecture, and is connected to a gate electrode of a second transistor through a step-down module; or the output terminal of the ET power supply or APT power supply is simultaneously connected to the drain electrodes of the first transistor and the second transistor in the Doherty architecture, and is connected to the gate electrode of the second transistor through the step-down module.

FIG. 3

**Description**

Technical Field

The invention belongs to the technical field of communication base station, in particular to a power amplifier circuit based on envelope tracking technology and a design method.

Background Art

At present, the power amplifier of the base station is designed with the Doherty architecture power amplifier circuit, which can balance the efficiency of outputting the average power and the linearity of outputting the peak power.

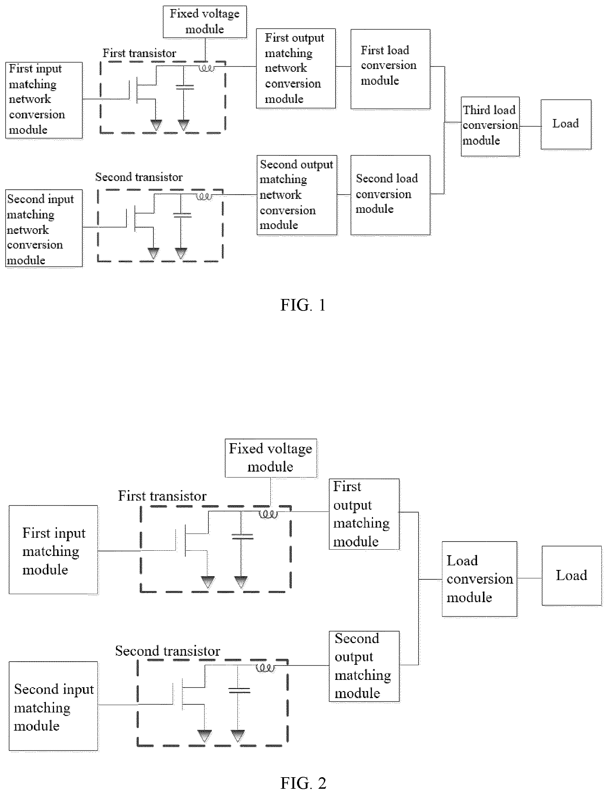

The structure principle of the traditional Doherty architecture power amplifier circuit suitable for narrow-band signals is shown in FIG. 1, including the Doherty architecture and the external power supply;

The Doherty architecture includes the first input matching network conversion module, the second input matching network conversion module, the first transistor, the second transistor, the first output matching network conversion module, the second output matching network conversion module, the first load conversion module, the second load conversion module and the third load conversion module;

The output terminal of the first input matching network conversion module is connected to the gate electrode of the first transistor; the output terminal of the second input matching network conversion module is connected to the gate electrode of the second transistor;

The first transistor is grounded to the source electrode of the second transistor;

The input terminal of the first output matching network conversion module is connected to the drain electrode of the first transistor; the input terminal of the second output matching network conversion module is connected to the drain electrode of the second transistor;

The input terminal of the first load conversion module is connected to the output terminal of the first output matching network conversion module, and the input terminal of the second load conversion module is connected to the output terminal of the second output matching network conversion module;

The input terminal of the third load conversion module is connected to the output terminals of the first load conversion module and the second load conversion module respectively;

The output terminal of the third load conversion module is connected to the external load;

The external power supply uses a fixed voltage module, and the output terminal of the fixed voltage module is connected to the drain electrode of the first transistor or connected to the drain electrodes of the first transistor and the second transistor respectively.

As the narrow-band characteristics of the traditional Doherty architecture power amplifier circuit gradually appear, domestic and foreign experts propose the double-matching Doherty architecture power amplifier circuit to solve the problem of narrower bandwidth, as shown in FIG. 2. The power amplifier circuit can solve the bandwidth problem well.

However, both Doherty architecture power amplifier circuit suitable for narrow bands and Doherty architecture power amplifier circuit suitable for broadbands have the following problems:

1. Since the fixed voltage module can only provide the fixed leakage voltage, the back-off of 3dB or 6dB of average output power expected by the base station occurs during operation; at this time, the power amplifier works in the linear region, and therefore it is difficult to guarantee the efficiency.

2. For the traditional Doherty architecture power amplifier circuit, the gate voltage of the first transistor is generally biased at Class AB, and the gate voltage of the second transistor is generally biased at Class C in order to ensure the high efficiency at the rated power. At the peak power, the first transistor and the second transistor cannot achieve complete in-phase power stacking due to different bias of gate voltage, so that the saturation power achieved by the traditional Doherty architecture is lower than that achieved by the first transistor and the second transistor for balancing the amplifier architecture (two transistors of the balanced amplifier have the same gate voltage and leakage voltage, which can achieve the complete in-phase stacking of two signals), which greatly reduces the linearity at the peak power, resulting in difficult improvement in linearity, which is necessarily achieved by a special pre-distortion algorithm.

Content of Invention

Aiming at the problems of difficult efficiency guarantee of the traditional Doherty architecture power amplifier circuit and poor linearity at peak power output, the invention proposes a power amplifier circuit based on envelope tracking technology.

Meanwhile, the invention provides a design method of the circuit.

The purpose of the invention is realized by adopting the following technical proposal:

A power amplifier circuit based on envelope tracking technology comprise a Doherty architecture and an external power supply; the external power supply is an ET power supply or APT power supply; the output terminal of the ET power supply or APT power supply is connected to a drain electrode of a first transistor in the Doherty architecture, and is connected to a gate electrode of a second transistor through a step-down module;

Or the output terminal of the ET power supply or APT power supply is simultaneously connected to the drain electrodes of the first transistor and the second transistor in the Doherty architecture, and is connected to the gate electrode of the second transistor through the step-down module.

The ET power supply or APT power supply regulates the gate voltage of the second transistor to ensure that the gate electrode of the second transistor is biased at Class C during rated power output to obtain the maximum efficiency and biased at Class AB during peak power output to ensure that the second transistor and the first transistor maintain the in-phase power stacking and then achieve the balanced amplifier effect to obtain the maximum saturation power.

Further, the step-down module comprises a resistor and an operational amplifier.

Further, the Doherty architecture is suitable for narrow-band signals, or a double-matching Doherty architecture suitable for broadband signals.

The invention also provides a design method of the power amplifier circuit based on envelope tracking technology, which includes the following steps:

Step 1: Determine the saturation power P1 of the power amplifier circuit according to the given input signal peak-to-average ratio (PAR) and average effective output Pave;

$$P1 = Pave + PAR;$$

Step 2: Determine the saturation power value P1/2 of a single transistor in the Doherty architecture;

Step 3: Perform loadpull simulation by using the simulation software and calling a single transistor model, adjust the leakage voltage of the single transistor model, record the corresponding leakage voltage value of the transistor model when the saturation power of the transistor model is P1/2, take the leakage voltage value as the maximum voltage value $V_{max}$ of the ET power supply or APT power supply, record the corresponding leakage voltage value of the transistor model when the saturation power of the transistor model is Pave, and take the leakage voltage value as the average effective voltage $V_{rms}$ of the ET power supply or APT power supply;

Step 4: Get the minimum voltage value $V_{min}$ of the ET power supply or APT power supply through the maximum voltage value $V_{max}$ and the average effective voltage value $V_{rms}$, and obtain the voltage range of the ET power supply or APT power supply to select the appropriate ET power supply or APT power supply;

The specific calculation formula is as follows:

$$V_{rms} = \frac{P_1 V_{\max} + P_2 V_{\min}}{2},$$

Wherein, $P_1$ and $P_2$ are positive factors whose values are both more than 0 and less than 1;

Step 5: Match the ET power supply or APT power supply with the transistor;

Step 5.1: Obtain the impedance R2 at the end face of Plan A of the output terminal for the transistor current source when the transistor outputs the average power according to the optimal load value R1 of the selected ET power supply or APT power supply and the drain efficiency DE when the transistor outputs the rated power;

The specific calculation formula is as follows:

$$\frac{V_{rms}^2 * DE}{R_1} = \frac{(V_{rms} - V_1)^2}{2R_2},$$

Wherein, V1 is the characteristic voltage of the transistor, and the drain efficiency DE for the transistor to output the rated power is obtained when Step 3 is performed.

Step 5.2: Convert the impedance of the load to the impedance R2 at the end face of Plan A of the output terminal for the transistor current source based on the Smith chart impedance transformation method to realize the matching of ET power supply or APT power supply with the transistor;

Step 6: The building of power amplifier circuit based on envelope tracking technology is completed.

Further, Further, Advanced Design System is used as the simulation software.

Compared with the prior art, the invention has the following beneficial technical effects:

1. Compared with the traditional Doherty architecture power amplifier circuit and the double-matching Doherty architecture power amplifier circuit, the power amplifier circuit proposed by the invention can realize the effective matching between the Doherty architecture and ET power supply or APT power supply; when the optimal load value of the ET (Envelope Tracking) power supply or APT (Average Power Tracking power supply and the equivalent resistance value of the transistor current source meet the matching conditions, the optimal matching effect between the ET power supply or APT power supply and the transistors can be achieved, so that the overall efficiency of the whole ET power supply or APT power supply + transistors is optimal; when the output power is 3dB or 6dB back-off of the rated power, the power amplifier also works in the saturation state at the back-off power due to the use of a lower voltage value than the fixed leakage voltage, which can effectively improve the efficiency at the output power.

2. The ET power supply or APT power supply of the invention is connected to the gate electrode of the second transistor through the step-down module to regulate the gate voltage of the second transistor, ensure that the gate electrode of the second transistor is biased at Class C during rated power output to obtain the maximum efficiency and biased at Class AB during peak power output, ensure that the second transistor and the first transistor maintain the in-phase power stacking and then achieve the balanced amplifier effect to obtain the maximum saturation power; after verification, the invention can effectively improve the overall efficiency of the ET/APT power supply + Doherty at the rated power during power back-off; in addition, the invention also greatly improves linearity, thus realizing the effective combination of ET/APT power supply + Doherty.

Description of Drawings

Various other advantages and benefits of the invention will become clear to the ordinary technicians in the field by reading the detailed description in the preferred embodiments below. The drawings to the specification are used only for the purpose of illustrating the preferred embodiments, but not considered to be a limitation to the invention. Obviously, the drawings described below only illustrate some embodiments of the invention, and other drawings may be obtained by the ordinary technicians in the field without creative effort according to these drawings. The same parts are represented by the same signs throughout the drawings.

FIG. 1 is the structure diagram of the traditional power amplifier circuit based on Doherty architecture suitable for narrow bands;
FIG. 2 is the structure diagram of the traditional power amplifier circuit based on Doherty architecture applicable to broadbands;
FIG. 3 is the structure diagram of the power amplifier circuit of the invention;
FIG. 4 is the comparison diagram of the power and efficiency relationship between the power amplifier circuit of the invention and the traditional Doherty architecture, the balanced amplifier architecture and the low leakage voltage Doherty architecture;
FIG. 5 is the comparison diagram of the power and efficiency relationship between the power amplifier circuit of the invention and the traditional Doherty architecture, the balanced amplifier architecture and the architecture with the ET/APT power supply that only regulates the Doherty drain voltage.

Embodiments

The embodiments of the invention are described in more detail with reference to the drawings below. Although the embodiments of the invention are illustrated in the drawings, it should be understood that the invention may be realized in various forms and should not be limited by the embodiments set forth herein. On the contrary, the embodiments are provided to enable a more thorough understanding of the invention and a complete communication of the scope of the invention to the technicians in the field.

It should be noted that certain terms are used in the specification and claims to refer to specific components. It should be understood by the technicians in the field that technicians may refer to the same component using different terms. In the specification and claims, the components are not distinguished by differences in terms, but distinguished by differences in component functions. For example, "comprise" or "include" mentioned throughout the specification and claims is an open term, so it should be interpreted as " including but not limited to". The subsequent description of the specification is the preferred embodiment of the invention, but the description is for the purpose of the general principles of the specification and is not intended to limit the scope of the invention. The scope of protection of the invention should be subject to the definition of the claims.

To understand the embodiments of the invention, the embodiments are further explained below in combination with the drawings, and the drawings do not constitute a limitation to the embodiments of the invention.

Envelope Tracking (ET) technology or Average Power Tracking (APT) technology can adjust the drain voltage of the power amplifier based on the size of the RF signal inputted by the power amplifier, which can ensure both the high linearity of peak signals and the high efficiency of mean signals and small signals.

The invention provides a power amplifier circuit based on envelope tracking technology, which comprises a Doherty architecture and an external power supply; the circuit is mainly improved in the following aspects: the external power supply is an ET power supply or APT power supply; the output terminal of the ET power supply or APT power supply is connected to a drain electrode of a first transistor in the Doherty architecture, and is connected to a gate electrode of a second transistor through a step-down module;

Or the output terminal of the ET power supply or APT power supply is simultaneously connected to the drain electrodes of the first transistor and the second transistor in the Doherty architecture, and is connected to the gate electrode of the second transistor through the step-down module.

The ET power supply or APT power supply regulates the gate voltage of the second transistor to ensure that the gate electrode of the second transistor is biased at Class C during rated power output to obtain the maximum efficiency and biased at Class AB during peak power output to ensure that the second transistor and the first transistor maintain the in-phase power stacking and then achieve the balanced amplifier effect to obtain the maximum saturation power.

When the ET power supply or APT power supply is connected to the drain electrode of the first transistor, the matching between the ET power supply or APT power supply and the first transistor is only needed; when the ET power supply or APT power supply is connected to the drain electrodes of the first transistor and the second transistor simultaneously, the envelope tracking power supply is required to be matched with the first transistor and the second transistor respectively.

However, the invention is not a simple combination of ET power supply or APT power supply and Doherty architecture. To achieve the optimal matching between the ET power supply or APT power supply and the Doherty architecture to ensure the output efficiency of the transistors and realize the optimal overall efficiency of the entire ET/APT + transistors, the invention also provides a design method of the circuit, including the following steps:

Step 1: Determine the saturation power P1 of the power amplifier circuit according to the given input signal peak-to-average ratio (PAR) and average effective output Pave;

$$P1 = Pave + PAR;$$

Step 2: Determine the saturation power value P1/2 of a single transistor in the Doherty architecture;
Step 3: Perform loadpull simulation by using the simulation software (Advanced Design System) and calling a single transistor model, adjust the leakage voltage of the single transistor model, record the corresponding leakage voltage value of the transistor model when the saturation power of the transistor model is P1/2, take the leakage voltage value as the maximum voltage value $V_{max}$ of the ET power supply or APT power supply, record the corresponding leakage voltage value of the transistor model when the saturation power of the transistor model is Pave, and take the leakage voltage value as the average effective voltage $V_{rms}$ of the ET power supply or APT power supply;
Step 4: Get the minimum voltage value $V_{min}$ of the ET power supply or APT power supply through the maximum voltage value $V_{max}$ and the average ef-

fective voltage value $V_{rms}$, and obtain the voltage range of the ET power supply or APT power supply to select the appropriate ET power supply or APT power supply;

The specific calculation formula is as follows:

$$V_{rms} = \frac{P_1 V_{\max} + P_2 V_{\min}}{2};$$

Wherein, $P_1$ and $P_2$ are positive factors whose values are both more than 0 and less than 1;

Step 5: Match the ET power supply or APT power supply with the transistor;
Step 5.1: Obtain the impedance R2 at the end face of Plan A of the output terminal for the transistor current source when the transistor outputs the average power according to the optimal load value R1 of the selected ET power supply or APT power supply and the drain efficiency DE when the transistor outputs the rated power;

The specific calculation formula is as follows:

$$\frac{V_{rms}^2 * DE}{R_1} = \frac{(V_{rms} - V_1)^2}{2R_2},$$

Wherein, V1 is the characteristic voltage of the transistor, and the drain efficiency DE for the transistor to output the rated power is obtained when Step 3 is performed.

Step 5.2: Convert the impedance of the load to the impedance R2 at the end face of Plan A of the output terminal for the transistor current source based on the Smith chart impedance transformation method to realize the matching of ET power supply or APT power supply with the transistor;
Step 6: The building of power amplifier circuit based on envelope tracking technology is completed.

Based on the above description of the circuit improvement idea and design method of the invention, the invention is introduced in detail according to the specific structure of the circuit:

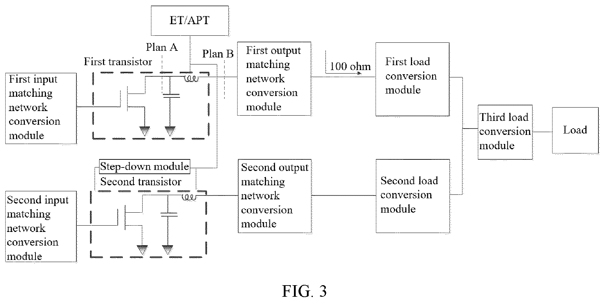

The embodiment provides a narrowband power amplifier circuit structure based on envelope tracking technology, as shown in FIG. 3, comprising a first input matching network conversion module, a second input matching network conversion module, a first transistor, a second transistor, an ET power supply or APT power supply, a first output matching network conversion module, a second output matching network conversion module, a first load conversion module, a second load conversion module and a third load conversion module;

The output terminal of the first input matching network conversion module is connected to the gate electrode of the first transistor; the output terminal of the second input matching network conversion module is connected to the gate electrode of the second transistor;

The first transistor is grounded to the source electrode of the second transistor; the first transistor and the second transistor respectively comprise an internal current source output terminal Plan A and an external output terminal Plan B;

The output terminal of the ET power supply or APT power supply is simultaneously connected to the drain electrodes of the first transistor and the second transistor, and is connected to the gate electrode of the second transistor through the step-down module to regulate the gate voltage of the second transistor, ensure that the gate electrode of the second transistor is biased at Class C during rated power output to obtain the maximum efficiency and biased at Class AB during peak power output, ensure that the second transistor and the first transistor maintain the in-phase power stacking and then achieve the balanced amplifier effect to obtain the maximum saturation power.

The input terminal of the first output matching network conversion module is connected to the drain electrode of the first transistor; the input terminal of the second output matching network conversion module is connected to the drain electrode of the second transistor;

The input terminal of the first load conversion module is connected to the output terminal of the first output matching network conversion module, and the input terminal of the second load conversion module is connected to the output terminal of the second output matching network conversion module;

The input terminal of the third load conversion module is connected to the output terminals of the first load conversion module and the second load conversion module respectively;

The output terminal of the third load conversion module is connected to the external load;

In the embodiment, the functions of all components are as follows:

The first input matching network conversion module and the second input matching network conversion module are used to match the maximum gain impedance of the first transistor and the second transistor to the preset impedance;

The first transistor and the second transistor are used for signal amplification to facilitate signal transmission;

The ET power supply or APT power supply is used to provide variable voltage to the first and/or second transistors to improve the efficiency of the power amplifier;

The first output matching network conversion module and the second output matching network conversion module are used to match the maximum power point impedance of the first transistor and the second transistor to the preset impedance respectively;

The first load conversion module is used to realize the high efficiency of the power amplifier when the first transistor outputs the rated power output;

The second load conversion module is used to realize no effect on the circuit (namely, from the first input matching network conversion module to the load) where the first transistor is located when the second transistor circuit is connected; any effect will cause the efficiency for the first transistor to output the rated power to become low;

The third load conversion module is used to convert the load impedance to the input point impedance of the third load conversion module.

In the embodiment, the first output matching network conversion module and the second output matching network conversion module, the first input matching network conversion module and the second input matching network conversion module are composed of microstrip lines and capacitors; the first transistor and the second transistor respectively comprise an equivalent resistor, a voltage-controlled current source, a parasitic inductor and a parasitic capacitor.

In the embodiment, during operation, the first input matching network conversion module matches the load impedance of 50 ohms to the maximum gain impedance of the first transistor; the first output matching network conversion module matches the load of 50 ohms to the maximum power point (end face of Plan B) impedance of the first transistor; the first load conversion module and the third load conversion module work together to match the load of 50 ohms to 100 ohms, and the first output matching network conversion module matches the resistance of 100 ohms to the end face of Plan A.

The first output matching network conversion module matches the converted resistance of 100 ohms to the end face of Plan A, which is different from the traditional embodiment in which the converted resistance of 100 ohms is matched to the maximum efficiency point of the power amplifier (end face of Plan B) impedance.

In FIG. 3, the end face of Plan A represents the output terminal of the internal current source for the first transistor, namely the node of the dotted line and the solid line of Plan A in FIG. 3; the end face of Plan B represents the external output terminal of the first transistor, namely the node of the dotted and the solid line of Plan B in FIG. 3.

In order to verify the effect, the invention also provides the following specific comparison and explanation:

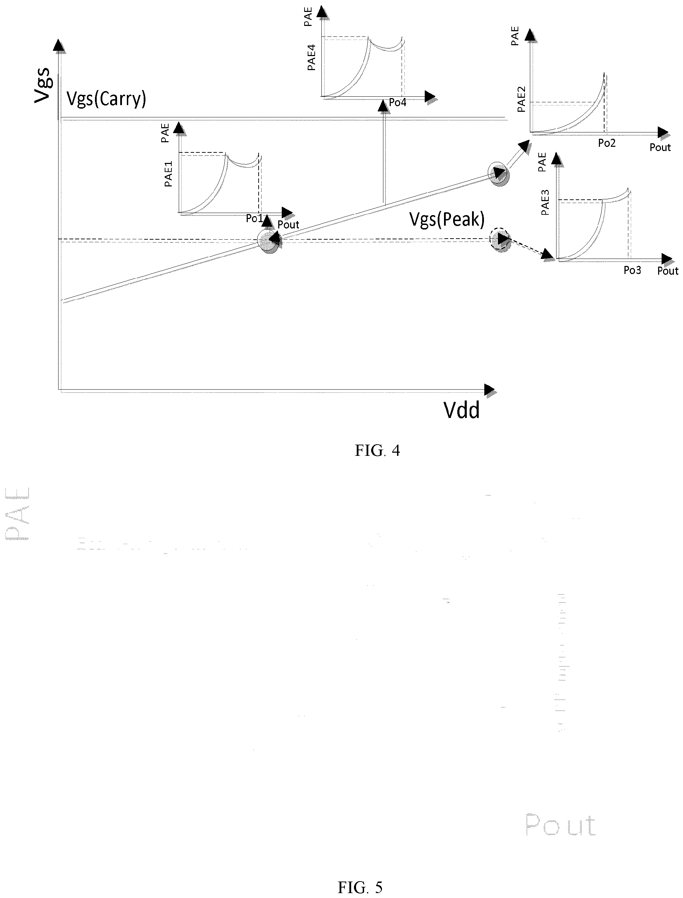

As shown in FIG. 4, the horizontal coordinate represents the leakage voltage, the vertical coordinate represents the gate voltage, and Vgs(carry) represents the gate voltage of the first transistor; Vgs(Peak) represents the gate voltage of the second transistor;

Wherein, Po1 represents the saturation power of the power amplifier circuit based on Doherty architecture (the external power supply is a fixed electrical module, ET power supply or APT power supply) in the state of low leakage voltage; Po2 represents the saturated power of the power amplifier circuit based on the balanced amplifier; Po3 represents the saturated power of the traditional Doherty power amplifier circuit (the external power supply is a fixed voltage module); Po4 represents the maximum saturation power that can be achieved when the ET power supply or APT power supply modulates Doherty leakage voltage and the gate voltage of the second transistor;

PAE1 represents the efficiency of the power amplifier circuit based on the Doherty architecture (the external power supply is a fixed module or ET power supply or APT power supply) when outputting the rated power under the low leakage voltage state; PAE2 represents the efficiency of the power amplifier circuit based on the balanced amplifier when outputting the rated power; PAE3 represents the efficiency of the traditional Doherty power amplifier circuit (the external power supply is a fixed voltage module) when outputting the rated power; PAE4 represents the efficiency when the ET power supply or APT power supply modulates Doherty leakage voltage and the gate voltage of the second transistor and then outputs the rated power.

FIG. 4 shows that Po1<Po3<Po4<=Po2 and PAE4>PAE1>PAE3>PAE2; obviously, only regulating the leakage voltage helps to improve the efficiency, but does not help to improve the linearity, and too large bias improves the linearity, but causes the efficiency decline. Therefore, the invention designs a proposal for modulating the Doherty leakage voltage and the gate voltage of the second transistor through the ET power supply or APT power supply, guaranteeing both the high efficiency at the rated power and the linearity of PA overall performance.

In FIG. 5, the curve 1 is the power and efficiency curve corresponding to the power amplifier circuit based on the balanced amplifier, the curve 2 is the power and efficiency curve corresponding to the traditional Doherty (the external power supply is a fixed voltage module) power amplifier circuit (namely, the fixed leakage voltage Doherty architecture), the curve 3 is the power and efficiency curve corresponding to the power amplifier circuit with the architecture that the ET power supply or APT power supply only modulating the Doherty leakage voltage, and the curve 4 is the power and efficiency curve corresponding to the power amplifier circuit of the invention that the ET power supply or APT power supply simultaneously modulates the Doherty leakage voltage and the gate voltage of the second transistor. As shown in FIG. 5, the ET power supply or APT power supply of the invention simultaneously modulates the Doherty leakage voltage and the gate voltage of the second transistor, not only guaranteeing both the high efficiency at the mean power, but also ensuring that the linearity at the peak power is close to the effect of the balanced amplifier, which are obviously better than the efficiency and linearity of the traditional voltage leakage Doherty.

Although the embodiments of the invention are described in combination with the drawings, the invention is not limited to the embodiments and application fields described above, and the above embodiments are only indicative and instructive, rather than restrictive. Inspired by the specification, the ordinary technicians in the field can also make a variety of forms without departing from the scope of protection of the claims of the invention, which fall within the scope of protection of the invention.

## Claims

1. A power amplifier circuit based on envelope tracking technology, comprising a Doherty architecture and an external power supply, and **characterized in that** the external power supply is an ET power supply or APT power supply; the output terminal of the ET power supply or APT power supply is connected to a drain electrode of a first transistor in the Doherty architecture, and is connected to a gate electrode of a second transistor through a step-down module;

   Or the output terminal of the ET power supply or APT power supply is simultaneously connected to the drain electrodes of the first transistor and the second transistor in the Doherty architecture, and is connected to the gate electrode of the second transistor through the step-down module;
   The ET power supply or APT power supply regulates the gate voltage of the second transistor to ensure that the gate electrode of the second transistor is biased at Class C during rated power output to obtain the maximum efficiency and biased at Class AB during peak power output to ensure that the second transistor and the first transistor maintain the in-phase power stacking and then achieve the balanced amplifier effect to obtain the maximum saturation power.

2. The power amplifier circuit based on envelope tracking technology according to Claim 1 **characterized in that** the step-down module comprises a resistor and an operational amplifier.

3. The power amplifier circuit based on envelope tracking technology according to Claim 1 or 2 **characterized in that** the Doherty architecture is suitable for narrow-band signals, or a double-matching Doherty architecture suitable for broadband signals.

4. A design method of the power amplifier circuit based on envelope tracking technology according to Claim 1, **characterized by** including the following steps:

   Step 1: Determine the saturation power P1 of the power amplifier circuit according to the given input signal peak-to-average ratio (PAR) and average effective output Pave;

   $$P1 = Pave + PAR;$$

   Step 2: Determine the saturation power value P1/2 of a single transistor in the Doherty architecture;
   Step 3: Perform loadpull simulation by using the simulation software and calling a single transistor model, adjust the leakage voltage of the single transistor model, record the corresponding leakage voltage value of the transistor model when the saturation power of the transistor model is P1/2, take the leakage voltage value as the maximum voltage value $V_{max}$ of the ET power supply or APT power supply, record the corresponding leakage voltage value of the transistor model when the saturation power of the transistor model is Pave, and take the leakage voltage value as the average effective voltage $V_{rms}$ of the ET power supply or APT power supply;
   Step 4: Get the minimum voltage value $V_{min}$ of the ET power supply or APT power supply through the maximum voltage value $V_{max}$ and the average effective voltage value $V_{rms}$, and obtain the voltage range of the ET power supply or APT power supply to select the appropriate ET power supply or APT power supply;
   The specific calculation formula is as follows:

   $$V_{rms} = \frac{P_1 V_{max} + P_2 V_{min}}{2},$$

   Wherein, $P_1$ and $P_2$ are positive factors whose values are both more than 0 and less than 1;
   Step 5: Match the ET power supply or APT power supply with the transistor;
   Step 5.1: Obtain the impedance R2 at the end face of Plan A of the output terminal for the transistor current source when the transistor outputs the average power according to the optimal load value R1 of the selected ET power supply or APT power supply and the drain efficiency DE when the transistor outputs the rated power;
   The specific calculation formula is as follows:

   $$\frac{V_{rms}^2 * DE}{R_1} = \frac{(V_{rms} - V_1)^2}{2R_2},$$

   Wherein, V1 is the characteristic voltage of the transistor, and the drain efficiency DE for the transistor to output the rated power is obtained when Step 3 is performed;
   Step 5.2: Convert the impedance of the load to the impedance R2 at the end face of Plan A of the output terminal for the transistor current source based on the Smith chart impedance transformation method to realize the matching of ET power supply or APT power supply with the transistor;
   Step 6: The building of power amplifier circuit based on envelope tracking technology is completed.

5. The design method of the power amplifier circuit based on envelope tracking technology according to Claim 4, **characterized in that** Advanced Design System is used as the simulation software.

Fixed voltage module

First transistor

First input matching network conversion module

First output matching network conversion module

First load conversion module

Third load conversion module

Load

Second transistor

Second input matching network conversion module

Second output matching network conversion module

Second load conversion module

FIG. 1

Fixed voltage module

First transistor

First input matching module

First output matching module

Load conversion module

Load

Second transistor

Second input matching module

Second output matching module

FIG. 2

ET/APT

First input matching network conversion module

Plan A — First transistor — Plan B

First output matching network conversion module — 100 ohm — First load conversion module

Step-down module — Second transistor

Second input matching network conversion module

Second output matching network conversion module — Second load conversion module

Third load conversion module — Load

FIG. 3

FIG. 4

FIG. 5

## INTERNATIONAL SEARCH REPORT

| International application No. |
| --- |
| **PCT/CN2022/085456** |

**A. CLASSIFICATION OF SUBJECT MATTER**

H03F 1/02(2006.01)i

According to International Patent Classification (IPC) or to both national classification and IPC

**B. FIELDS SEARCHED**

Minimum documentation searched (classification system followed by classification symbols)

H03F

Documentation searched other than minimum documentation to the extent that such documents are included in the fields searched

Electronic data base consulted during the international search (name of data base and, where practicable, search terms used)

CNABS; CNTXT; DWPI; VEN; ENTXT; USTXT; WOTXT; EPTXT; CNKI; IEEE: 多尔蒂, 功率放大器, 电源, 晶体管, 偏置; Doherty, power amplifier, power supply, transistor, bias

**C. DOCUMENTS CONSIDERED TO BE RELEVANT**

| Category* | Citation of document, with indication, where appropriate, of the relevant passages | Relevant to claim No. |
| --- | --- | --- |
| PX | CN 114285378 A (SHAANXI SUB FINISHED MICROELECTRONIC CO., LTD.) 05 April 2022 (2022-04-05)<br> description, paragraphs 15-99, and figures 1-4 | 1-5 |
| Y | CN 101350599 A (HUAWEI TECHNOLOGIES CO., LTD.) 21 January 2009 (2009-01-21)<br> description, page 3, paragraph 7-page 9, last paragraph, and figures 1-5 | 1-3 |
| A | CN 101350599 A (HUAWEI TECHNOLOGIES CO., LTD.) 21 January 2009 (2009-01-21)<br> description, page 3, paragraph 7-page 9, last paragraph, and figures 1-5 | 4-5 |
| Y | CN 101527545 A (COMBA TELECOM SYSTEM HOLDINGS LTD.) 09 September 2009 (2009-09-09)<br> description, page 4, paragraph 1-page 15, paragraph 2, and figures 1-11 | 1-3 |
| A | CN 101527545 A (COMBA TELECOM SYSTEM HOLDINGS LTD.) 09 September 2009 (2009-09-09)<br> description, page 4, paragraph 1-page 15, paragraph 2, and figures 1-11 | 4-5 |
| A | CN 103107778 A (SOUTHEAST UNIVERSITY) 15 May 2013 (2013-05-15)<br> entire document | 1-5 |

☐ Further documents are listed in the continuation of Box C.  ☑ See patent family annex.

| | |
| --- | --- |
| \*    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| **11 August 2022** | **26 August 2022** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/085456**

| Patent document cited in search report | | | Publication date (day/month/year) | Patent family member(s) | | | Publication date (day/month/year) |
|---|---|---|---|---|---|---|---|
| CN | 114285378 | A | 05 April 2022 | None | | | |
| CN | 101350599 | A | 21 January 2009 | WO | 2010022613 | A1 | 04 March 2010 |
| | | | | CN | 101350599 | B | 03 November 2010 |
| CN | 101527545 | A | 09 September 2009 | None | | | |
| CN | 103107778 | A | 15 May 2013 | CN | 103107778 | B | 02 March 2016 |

Form PCT/ISA/210 (patent family annex) (January 2015)